Europäisches Patentamt

European Patent Office

Office européen des brevets

(11) Numéro de publication : **0 455 526 A1**

## (12) DEMANDE DE BREVET EUROPEEN

(21) Numéro de dépôt : **91400907.1**

(51) Int. Cl.⁵ : **H01L 21/20**

(22) Date de dépôt : **03.04.91**

(30) Priorité : **13.04.90 FR 9004814**

(43) Date de publication de la demande :
**06.11.91 Bulletin 91/45**

(84) Etats contractants désignés :
**DE GB IT NL**

(71) Demandeur : **THOMSON-CSF**
**51, Esplanade du Général de Gaulle**
**F-92800 Puteaux (FR)**

(72) Inventeur : **Weisbuch, Claude**
**THOMSON-CSF, SCPI-Cedex 67**
**F-92045 Paris la Defense (FR)**
Inventeur : **Hirtz, Jean-Pierre**
**THOMSON-CSF, SCPI-Cedex 67**
**F-92045 Paris la Defense (FR)**
Inventeur : **Bisaro, René**
**THOMSON-CSF, SCPI-Cedex 67**
**F-92045 Paris la Defense (FR)**

(74) Mandataire : **Taboureau, James et al**
**THOMSON-CSF SCPI**
**F-92045 Paris La Défense Cédex 67 (FR)**

(54) **Procédé d'adaptation entre deux matériaux semiconducteurs cristallisés et dispositif semiconducteur.**

(57)    L'invention concerne un procédé de croissance, sur un substrat en un premier matériau (5), d'une couche en un second matériau (7), dont les paramètres de maille cristalline sont désadaptés.

Afin d'éviter la courbure du substrat, résultant de la contrainte imposée par la désadaptation entre les paramètres de maille des deux matériaux (5,7), le substrat est d'abord soumis à une contrainte calculée, par introduction dans son réseau cristallin de domaines déformants (6) qui induisent une contrainte inverse de celle imposée ensuite, par la croissance de la couche de second matériau. Selon les coefficients de dilatation linéaire des deux matériaux, la couche est épitaxiée sur la même face ou sur la face opposée du substrat contrainte par les domaines déformants.

Application aux dispositifs semiconducteurs GaAs/Si.

# FIG_5

EP 0 455 526 A1

La présente invention concerne un procédé de croissance d'une couche d'un matériau, ayant un paramètre de maille cristalline donné, sur un substrat en un matériau différent, ayant un paramètre de maille différent. L'invention s'applique essentiellement aux matériaux semiconducteurs et elle comprend les dispositifs semiconducteurs obtenus à partir des matériaux dont la croissance a été réalisée par le procédé décrit ci-après.

Depuis quelques années déjà, la tendance est d'allier les caractéristiques les plus intéressantes de divers matériaux semiconducteurs pour réaliser des circuits électroniques plus performants. Par exemple réunir sur une même puce des matériaux du groupe III-V, ayant des applications en optoélectronique ou réputés pour les circuits hyperfréquences, et du silicium bien maîtrisé pour les circuits à haute intégration et dont les caractéristiques mécaniques et thermiques sont intéressantes.

On sait par exemple qu'une tranche de silicium est moins fragile qu'une tranche de GaAs, a une bonne conductivité thermique et est plus économique. Il est donc apparu assez tôt qu'il serait intéressant de réaliser des circuits en GaAs sur un substrat silicium, pour allier la rapidité de GaAs à la densité d'intégration et à la conductibilité thermique du silicium.

En fait, ce type de réalisation se heurte à un certain nombre de difficultés, dont la plus couramment citée concerne la structure cristalline : GaAs et Si ne cristallisent pas dans le même système, et ont des paramètres de mailles différents : a = 5,43088 A° à 300 °K pour Si en structure diamand, et a = 5,6528 A° à 300 °K pour GaAs, en structure zinc-blende. La différence relative de paramètres de maille $\Delta$ a/a = 4,1 % est source de dislocations de Lohmer et de dislocations 60° à l'interface de l'hétéroépitaxie. Elles permettent l'adaptation partielle de la maille de GaAs sur celle de Si, mais sont à l'origine de défauts dans GaAS qui altèrent les propriétés électroniques des circuits.

De nombreux travaux ont été publiés qui visent à obtenir l'adaptation entre les paramètres de mailles, de façon à limiter la densité de défauts, mais tous utilisent une couche tampon entre les deux matériaux désacordés.

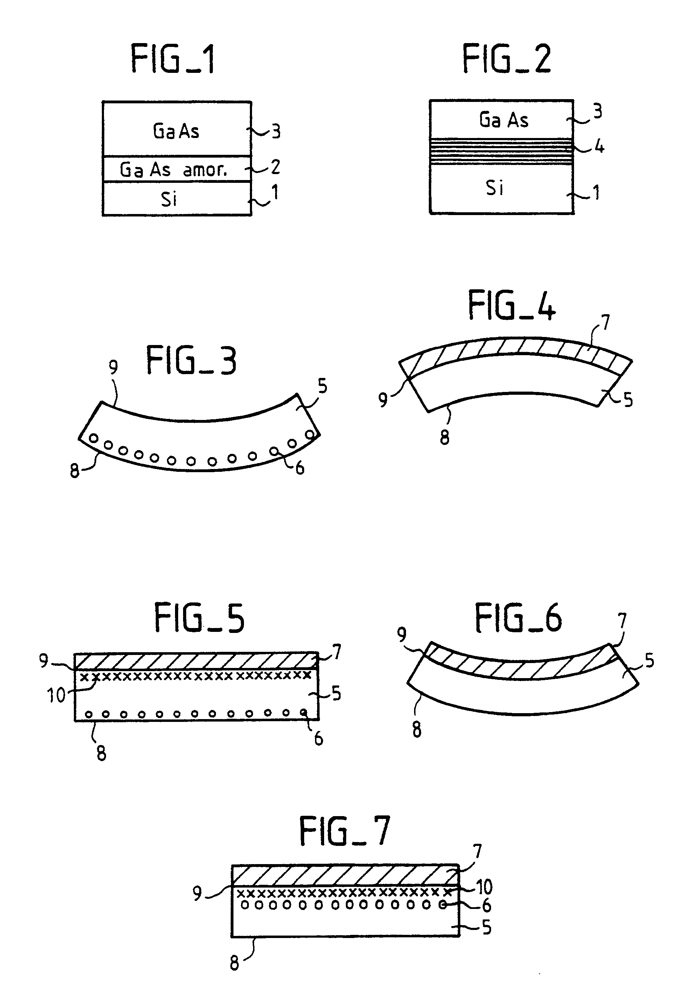

A titre d'exemple, la figure 1 schématise une solution bien connue : sur un substrat 1 en Si monocristallin, on fait croître à basse température une couche 2 de GaAs amorphe, d'épaisseur inférieure à 4 micromètres, puis une couche 3 de GaAs polycristallin.

Une autre solution connue, illustrée en figure 2, consiste à faire croître, sur le substrat 1 en Si, un super-réseau 4 de couches en tension, par épitaxie d'organométalliques connue sous le sigle MOCVD (métalorganic chemical vapour deposition, en anglais), avant d'épitaxier la couche 3 de GaAs superficielle. La réalisation de tels super-réseaux comprend avantageusement une chaîne de matériaux peu désaccordés entre eux : par exemple AlP ou GaP (a = 5,4510 et 5,4512 A°) qui sont peu désaccordés avec le silicium ( a = 5,43088 A° ), puis GaP-/GaAsP, puis GaAsP/GaAs.

Néanmoins, si les différents procédés connus permettent de limiter le nombre de dislocations, il ne s'opposent pas à la courbure du substrat, sous l'effet des forces de contrainte ou de tension exercées à l'interface entre les deux matériaux. Pour un substrat de 320 micromètres d'épaisseur, recouvert d'une couche de GaAs comprise entre 1 et 4 micromètres d'épaisseur, le rayon de courbure varie entre 20 et 5 m, ce qui signifie qu'un substrat de 2" de diamètre (~5 cm) peut avoir une flèche jusque 50 micromètres, ce qui constitue une gêne considérable pour les opérations de masquage ou d'implantation, dans les couches d'épaisseur de l'ordre du micromètre, et pour des motifs pour lesquels on recherche fréquemment une largeur submicronique (grilles des transistors à effet de champ).

Le procédé selon l'invention a un double objectif. Il induit dans le substrat, en un premier matériau, une déformation préalable ou courbure, calculée et placée sur l'une ou l'autre face du substrat, de façon à s'opposer et à annuler la déformation qui sera introduite par la croissance, sur le substrat, d'une couche du second matériau. Un deuxième objectif est de modifier le structure cristalline en surface du substrat afin d'en adapter le paramètre de maille à celui de la couche du second matériau.

La déformation du substrat, pour lui imposer une courbure inverse de celle qu'il subira après l'épitaxie, est obtenue en insérant à faible profondeur dans le réseau cristallin des atomes dont le volume atomique est différent de celui du matériau du substrat, et qui soumettent ainsi le réseau cristallin à des forces de contrainte ou de tension, induisant une courbure de la plaquette de substrat dans un sens ou dans l'autre (convexité ou concavité). Le moyen le plus commode pour insérer des atomes est l'implantation ionique.

Ce même moyen peut en outre être avantageusement utilisé pour modifier la maille cristalline du substrat, en surface, pour favoriser la croissance de la couche du second matériau, en limitant le nombre de dislocations. Selon les paramètres de mailles et les coefficients de dilatation linéaire des deux matériaux, les implantations se font sur une seule ou sur deux faces du substrat.

De façon plus précise, l'invention concerne un procédé d'adaptation entre deux matériaux semiconducteurs cristallisés, en vue d'obtenir une structure plane par croissance, sur un substrat en un premier matériau, d'une couche en un second matériau, les dits matériaux ayant des paramètres de mailles cristallines désadaptés, caractérisé en ce que, dans une première étape, le substrat est déformé par introduction dans son réseau cristallin de domaines déformants qui induisent une contrainte du substrat, annulée, dans une deuxième étape, par la contrainte inverse imposée par la croissance de la couche de second matériau sur le dit substrat.

L'invention sera mieux comprise par la description plus détaillée qui suit maintenant du cas général et d'un cas particulier, en liaison avec les figures jointes en annexe, qui représentent :

– figures 1 et 2 : deux exemples de couches d'adaptation entre deux matériaux différents, selon l'art connu, exposées précédemment,

– figure 3 : vue en coupe d'un substrat, déformé par implantation, première étape de l'invention,

– figure 4 : vue en coupe d'un substrat, déformé par épitaxie, seconde étape de l'invention,

– figure 5 : vue en coupe du même substrat non déformé, résultant des deux étapes de l'invention,

– figure 6 : vue en coupe d'un substrat de Si sur lequel est déposée une couche de GaAs, sans la correction apportée par l'invention,

– figure 7 : vue en coupe d'un substrat de Si, compensé selon l'invention, avec une couche superficielle de GaAs.

Le procédé selon l'invention concerne tous les matériaux cristallisés, mais il est plus particulièrement intéressant pour les matériaux des groupes IV, III-V, II-VI et IV-VI utilisés dans l'industrie des semiconducteurs. C'est la raison pour laquelle le fondement du procédé va d'abord être exposé en s'appuyant sur les figures 3 à 5.

Considérons, en figure 3, une rondelle, ou "wafer", d'un premier matériau semiconducteur 5, monocristallin, qui sert de substrat pour la suite des opérations. Ce matériau a un premier paramètre de maille cristalline $a_1$, défini à 300° K, et un premier coefficient de dilatation linéaire $\delta_1$. Cette rondelle a par exemple un diamètre de 2 pouces et une épaisseur de l'ordre de 300-350 micromètres : elle est à l'origine parfaitement plane.

Le second matériau semiconducteur 7 que l'on veut faire croître sur ce substrat 5 a un second paramètre de maille cristalline $a_2$ et un second coefficient de dilatation linéaire $\delta_2$. Des procédés courants pour faire croître une couche de second matériau sur un substrat sont par exemple l'épitaxie par jet moléculaire MBE (molecular beam epitaxy, en anglais) ou l'épitaxie en phase vapeur par organo-métalliques.

Connaissant $a_1$, $a_2$, $\delta_1$ et $\delta_2$, on sait que la couche 7 épitaxiée sur le substrat 5, avec lequel elle est désaccordée, va exercer des forces de contrainte ou de tension sur le réseau cristallin, qui vont déformer la mince plaquette de substrat 5, et lui imprimer une courbure, soit en convexité (contrainte) soi en concavité ( tension ). Admettons, pour simplifier l'exposé, que la couche 7 rend le substrat 5 convexe, comme représenté en figure 4, c'est à dire que le second matériau 7 distend le réseau cristallin du premier matériau 5, lorsque toutes les opérations sont terminées, et la rondelle étant revenue à température ambiante.

Pour éviter cette déformation du substrat, l'invention propose de commencer dans une première étape par induire dans le substrat une déformation de sens opposé à celle qui sera induite dans une deuxième étape par l'épitaxie du second matériau.

Dans l'exemple choisi, il convient donc de gonfler la maille cristalline du substrat 5 sur sa deuxième face principale 8, pour annuler le gonflement de maille induit par le second matériau sur la première face 9 du substrat. Ce gonflement, on dilatation, de la maille cristalline, se fait commodément par implantation ionique d'atomes de fort volume atomique, selon une technique proche de la technologie connue sous le nom Simox.

Dans cette technologie, qui concerne un substrat de silicium, on implante de l'oxygène, sous une énergie de 150 KeV, à 600-1200° C, dans du silicium pour former de la silice $SiO_2$. Il est connu que le maximum de densité d'atomes d'oxygène implantés est situé sous la surface du silicium, en raison de la très forte énergie mise en oeuvre. Par un recuit approprié, on peut alors précipiter la silice en une couche continue et régulière, d'épaisseur de l'ordre de 3 micromètres, située sous une couche de silicium d'excellente qualité, exempte d'oxygène. La silice ayant un volume atomique par atome de silicium pratiquement double de celui du silicium, celui-ci se trouve en extension, il y a gonflement de sa maille cristalline.

Le procédé selon l'invention met en oeuvre une technologie qui en est dérivée. On implante, sous les mêmes conditions d'énergie et de température, environ dix fois moins d'oxygène que dans le procédé Simox, ce qui ne mène pas à la formation d'une couche continue de $SiO_2$ mais à la formation de domaines isolés de silice, repérés en 6 sur la figure 3. Ceux-ci créent des déformations du réseau cristallin, un gonflement qui mène à une courbure de la rondelle de substrat. L'implantation de domaines de $SiO_2$ est faite sur l'une ou l'autre face du substrat, de telle façon que les deux contraintes créées par l'implantation et par l'épitaxie d'un second matériau s'annulent.

C'est ce qui est représenté en figure 5, qui représente un substrat épitaxié en surface, à l'issue des deux opérations et revenu à température ambiante. Dans une première étape, correspondant à la figure 3, ce substrat est volontairement déformé dans un sens par une implantation ionique, qui forme les domaines 6. Dans une deuxième étape, correspondant à la figure 4, l'épitaxie du second matériau 7 impose une déformation qui annule la déformation induite volontairement : le substrat est plan.

De façon plus générale, de nombreux ions ou atomes peuvent être implantés : des métaux ou des métalloïdes dopants ou non dopants, mais l'oxygène, le carbone et l'azote sont les plus couramment utilisés, qui mènent à des domaines de SiO$_2$, SiC, Si$_3$N$_4$. Suivant la dose implantée, les températures de recuits, les nécessités d'obtenir une déformation dans un sens ou l'autre, on peut former des domaines déformants de composés stoéchimétriques ou s'arrêter à la formation de liaisons chimiques Si-O, Si-C, Si-N, mais dans tous les cas il y a déformation du réseau cristallin.

Jusqu'ici n'a été considérée que la courbure induite dans le substrat 5 par l'épitaxie d'un matériau 7 désadapté, et l'invention propose un moyen pour obtenir un substrat plan. Cependant, il faut également tenir compte de l'interface entre le substrat 5 et la couche épitaxiée 7, qui par définition sont désadaptés. Si les caractéristiques opératoires - paramètres de mailles, coefficients de dilatation thermique - sont tels que l'implantation d'atomes déformants 6 se fait sur une face 8 du substrat 5 et l'épitaxie du matériau 7 se fait sur une autre face 9 du substrat, il y a désadaptation au niveau de l'interface 9.

Il faut alors introduire une étape intermédiaire, au cours de laquelle une implantation d'atomes déformants, sous la face 9, adapte le paramètre de maille du substrat à celui du matériau épitaxié. Cette seconde implantation se fait à une dose inférieure à celle de la première implantation sous la face 8, sinon les courbures induites par les deux implantations s'annuleraient. La dose de la seconde implantation dépend des deux matériaux en présence. Elle donne une couche 10, en figure 5, d'adaptation entre les deux matériaux.

La face sur laquelle doit être faite la première implantation 6 ne dépend pas seulement des paramètres de maille, mais aussi des coefficients de dilatation respectifs. Le cas de GaAs épitaxié sur Si est intéressant. GaAs a un paramètre de maille a = 5,6528 A°, ce qui devrait donner une déformation conforme à la figure 4, selon laquelle le silicium 5 contraint l'arséniure de gallium 7, avec concavité du côté du substrat (face 8).

En fait, cette figure est valable pendant la croissance de GaAs, à des températures comprises entre 600° et 1200° C, parce que, après le refroidissement, à l'issue de l'épitaxie, le coefficient de dilatation linéaire de GaAs ( 6, 86. 10$^{-6}$/°K) impose au contraire une déformation illustrée en figure 6, avec convexité du côté du substrat (face 8).

Encore faut-il tenir compte de l'épaisseur de la couche de GaAs. En effet, la contrainte d'inadaptation (paramètres de mailles), qui agit comme une force compressive (vue de côté silicium) à deux dimensions, domine dans les couches de GaAs d'épaisseurs inférieures à 0,3 micromètres : le substrat silicium impose son réseau cristallin, ce qui donne la déformation de la figure 4. Au contraire, la contrainte thermique (coefficients de dilatation), qui agit comme une force d'extension (vue du côté GaAs) à deux dimensions, domine dans les couches de GaAs d'épaisseurs supérieures à 0,3 micromètres : la couche de GaAs impose son réseau cristallin, ce qui donne la déformation de la figure 6.

Par conséquent, dans le cas courant où une couche 7 de GaAs, d'épaisseur supérieure à 0,3 micromètres, est épitaxiée sur un substrat 5 de silicium, il faut pratiquer une ou deux implantations sur la face 9 du substrat 5 qui portera la couche épitaxiée 7, tel que représenté en figure 7. Par une première implantation on crée des domaines déformants 6 qui communiquent au substrat un gonflement de son réseau cristallin, avec courbure convexe de la face 9. Si nécessaire, une seconde implantation, à dose moins élevée, adapte le paramètre de maille de la couche 10 sous la face 9. Puis la croissance par épitaxie de la couche 7 de GaAs, sur cette même face 9, impose une courbure concave qui annule la courbure convexe précédente : la plaquette épitaxiée est plane.

L'implantation n'est pas la seule méthode qui permette de modifier la maille d'un cristal. La croissance de couches de n'importe quel matériau : métal, oxyde, nitrure, matériau semiconducteur..., non adapté en maille par une méthode telle que l'épitaxie, peut induire une courbure du substrat dans un sens tel que l'épitaxie d'un second matériau, lui aussi désadapté en maille, annule la dite courbure, et donne un substrat épitaxié n'ayant que peu de dislocations à l'interface.

Le procédé selon l'invention s'applique, notamment, à la réalisation de dispositifs semiconducteurs tels que transistors et circuits intégrés alliant les propriétés d'au moins deux matériaux semiconducteurs différents : ils sont caractérisé par la présence dans le substrat de domaines déformants du réseau cristallin, qui permettent l'adaptation des paramètres de maille, sans dislocations dans la couche épitaxiée.

## Revendications

1 - Procédé d'adaptation entre deux matériaux semiconducteurs cristallisés, en vue d'obtenir une structure plane par croissance sur un substrat en un premier matériau (5), d'une couche en un second matériau (7), les dits matériaux (5,7) ayant des paramètres de mailles cristallines désadaptés, caractérisé en ce que, dans une première étape, le substrat (5) est déformé par introduction dans son réseau cristallin de domaines déformants (6) qui induisent une contrainte du substrat, annulée, dans une deuxième étape, par la contrainte inverse imposée par la croissance de la couche de second matériau (7) sur le dit substrat.

2 - Procédé selon la revendication 1, caractérisé en ce que, les deux matériaux ayant des coefficients de dilatation linéaire sensiblement adaptés, les domaines déformants ( 6) sont introduits sous une première face (8) du substrat (5) et la croissance de la couche (7) est faite sur une deuxième face (9) du substrat (5).

3 - Procédé selon la revendication 1, caractérisé en ce que, les deux matériaux ayant en outre des coefficients de dilatation linéaire désadaptés, dont l'effet contrarie la désadaptation entre les paramètres de maille, les domaines déformants (6) sont introduits sous la même face (9) du substrat (5) que celle sur laquelle est faite la croissance de la couche (7) de second matériau.

4 - Procédé selon la revendication 1, caractérisé en ce que les domaines déformants (6) sont obtenus par implantation d'ions dans le premier matériau (5), sous forte énergie afin que les domaines soient sous la surface (8) du substrat.

5 - Procédé selon la revendication 4, caractérisé en ce que les ions sont des métaux ou des métalloïdes, et donnent après recuit entre 600 et 1200° C des domaines d'oxydes, de nitrures, de carbures, dont le volume atomique est plus gros que le volume atomique du premier matériau (5) du substrat.

6 - Procédé selon la revendication 1, caractérisé en ce que les domaines déformants (6) sont obtenus par la croissance par épitaxie, sur une première face du substrat (5), d'une couche d'un matériau dont la contrainte s'oppose à la contrainte induite par la couche (7) épitaxiée sur la seconde face (9) du substrat (5).

7 - Procédé selon la revendication 2, caractérisé en ce que, avant croissance de la couche en second matériau (7) sur la seconde face (9) du substrat (5), une étape intermédiaire d'introduction de domaines déformants communique à la dite seconde face (9) une couche (10) du premier matériau (5) adapté en paramètre de maille avec le second matériau.

8 - Dispositif semiconducteur, comprenant un substrat en un premier matériau (5) sur lequel est épitaxiée au moins une couche d'un second matériau (7), dont les paramètres de mailles cristallines sont désadaptées, caractérisé en ce que, en vue de conserver la planéité du substrat, celui-ci comporte, à proximité d'une face (8, 9), une région contrainte par des domaines déformants ( 6 ) introduits dans son réseau cristallin.

FIG_1

FIG_2

FIG_3

FIG_4

FIG_5

FIG_6

FIG_7

EP 0 455 526 A1

Office européen
des brevets

**RAPPORT DE RECHERCHE EUROPEENNE**

Numéro de la demande

EP 91 40 0907

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| X | US-A-4 159 214 (D. MASON) * Abrégé; colonne 3, ligne 9 - colonne 5, ligne 15; revendications * | 1,2,8 | H 01 L 21/20 |
| Y | | 7,6 | |
| | --- | | |
| X | US-A-4 766 092 (KURODA et al.) * Colonne 4, ligne 5 - colonne 7, ligne 46 * | 1,3,4 | |
| Y | | 7 | |
| | --- | | |
| Y | PATENT ABSTRACTS OF JAPAN, vol. 11, no. 70 (E-485)[2517], 3 mars 1987; & JP-A-61 225 816 (SHARP) 29-03-1985 * En entier * | 6 | |
| | --- | | |
| A | PATENT ABSTRACTS OF JAPAN, vol. 8, no. 17 (E-223)[1454], 25 janvier 1984; & JP-A-58 180 018 (SANYO) 14-04-1982 * En entier * | 2,7 | |
| | --- | | |
| A | ELECTRONICS LETTERS, vol. 24, no. 1, janvier 1988, pages 67-68, Stevenage, Herts, GB; K. DAS et al.: "Molecular beam epitaxial growth of GaAs on silicon with buried implanted oxides" * En entier * | 5 | **DOMAINES TECHNIQUES RECHERCHES (Int. Cl.5)** H 01 L |
| | --- | | |
| A | APPL. PHYS. LETT., vol. 37, no. 2, juillet 1980, pages 218-220, New York, US; R.K. TSUI et al.: "Plastic deformation and fracture resulting from stresses caused by differential thermal constraction in GaP/Si heterostructures" | | |
| | ----- | | |

Le présent rapport a été établi pour toutes les revendications

| Lieu de la recherche | Date d'achèvement de la recherche | Examinateur |
|---|---|---|
| LA HAYE | 19-07-1991 | GELEBART Y.C.M. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P0402)

7